# EUROPEAN PATENT APPLICATION

(11) **EP 4 492 410 A1**
(43) Date of publication of application: **15.01.2025**
(21) Application number: 23766671.4
(22) Date of filing: 01.03.2023
(51) Int. Cl.: H01F 1/37, H01F 1/34, H01F 3/02, H01P 11/00, H01Q 7/06, H05K 9/00

(54) **ELONGATE FERRITE SHEET AND CABLE USING SAME, AND METHOD FOR MANUFACTURING ANTENNA DEVICE USING SAME**

(30) Priority: 09.03.2022 JP 2022036654
(71) Applicant: Toda Kogyo Corp., Hiroshima-shi, Hiroshima 732-0828 (JP)
(72) Inventor: YOSHIDA, Akihiro, Otake-shi, Hiroshima 739-0652 (JP); OHMAE, Satoshi, Otake-shi, Hiroshima 739-0652 (JP); KIMURA, Tetsuya, Otake-shi, Hiroshima 739-0652 (JP); OKANO, Yoji, Otake-shi, Hiroshima 739-0652 (JP)
(74) Representative: Greaves Brewster LLP
(86) International application number: PCT/JP2023/007575
(87) International publication number: WO 2023/171495

(57) **Abstract**

A ferrite sheet (1) is a ferrite sheet (1) including a base material (10) and a ferrite sintered plate (20) provided on a surface of the base material (10). The ferrite sintered plate (20) continuously extends in the longitudinal direction of the base material (10), and has a length of not less than 0.3 m in the longitudinal direction.

## Description

### TECHNICAL FIELD

The present disclosure relates to an elongate ferrite sheet and a cable using same, and a method for manufacturing an antenna device using same.

### BACKGROUND ART

An IC tag has conventionally been known that has an IC chip and an antenna device electrically connected to the IC chip and performs power reception from a reader/writer and signal transmission and reception to and from the reader/writer in a non-contact manner by using an electromagnetic wave. In recent years, the IC tag has been embedded in cards and used in tickets of transportation facilities, credit cards and the like as IC cards. The antenna device provided on the IC tag is typically manufactured by winding a conducive wire around the base material to form a coil and also manufactured by printing a coil pattern on a surface of the base material.

When the antenna device is provided in the neighborhood of a metallic material such as a metallic card, a problem is caused in that the communication range is reduced and communication cannot be performed because the magnetic flux is converted as eddy current by the metal. For this reason, in order to prevent such a problem, a method is widely adopted in which a soft magnetic sheet is laminated between the conductive loop coil and the metallic material. The lamination of the soft magnetic sheet forms a route that the magnetic flux can pass through, so that communication properties can be improved.

As a material for the soft magnetic sheet as described above, for example, ferrite is used (for example, see Patent Literatures 1 and 2). While a ferrite sheet used as the soft magnetic sheet is usually distributed as a rectangle sheet laminated with an approximately 100 mm x 100 mm ferrite sintered plate, a belt-shaped (elongate) ferrite sheet is also demanded in terms of ease of handling by the user (for example, see Patent Literature 3).

### CITATION LIST

### PATENT LITERATURE

[Patent Literature 1] Japanese Laid-Open Patent Publication No. 2008-124197 A
[Patent Literature 2] Japanese Laid-Open Patent Publication No. 2009-113370 A
[Patent Literature 3] Japanese Laid-Open Patent Publication No. 2009-123771 A

### SUMMARY OF INVENTION

### TECHNICAL PROBLEM

Although the elongate ferrite sheet is considered to be rolled before use in terms of storage and portability, the ferrite sheet easily breaks because it is formed of a ferrite sintered body, and its size is limited such that the length is less than approximately 300 mm because of the sizes of the jig and the firing furnace for producing a flat ferrite sintered body. This makes it difficult to form a ferrite sheet in an elongate shape and roll it. Therefore, it is alternatively considered to form an elongate ferrite sheet by arranging a plurality of approximately 100 mm x 100 mm rectangular ferrite sintered plates on an elongate base material in the longitudinal direction of the elongate base material.

However, if a plurality of ferrite sintered plates overlap with each other, a problem occurs in that the appearance deteriorates at the overlapping parts and magnetic properties change. To solve this problem, it is considered to provide a gap between a plurality of ferrite sintered plates in consideration of pasting tolerances. However, in a case where such an elongate ferrite sheet is applied, for example, to an antenna device and rolled around a cable or the like for use, the presence of the gaps deteriorates the appearance of the ferrite sheet and can adversely affect the magnetic properties.

The present disclosure is made in view of the above-mentioned problem, and an object thereof is to provide an elongate ferrite sheet where there is neither overlapping between ferrite sintered plates nor gap between the ferrite sintered plates at the time of pasting of the ferrite sintered plates to the base material.

### SOLUTION TO PROBLEM

To attain the above-mentioned object, according to the present disclosure, an elongate ferrite sheet has not a structure in which a plurality of ferrite sintered plates are pasted to a surface of the base material but a structure using a ferrite sintered plate continuously extending in the longitudinal direction.

Specifically, an elongate ferrite sheet according to the present disclosure comprises an elongate base material and a ferrite sintered plate provided on a surface of the base material, wherein the ferrite sintered plate continuously extends in a longitudinal direction of the base material, and wherein the elongate ferrite sheet has a length of not less than 0.3 m in the longitudinal direction.

The elongate ferrite sheet according to the present disclosure is not an elongate ferrite sheet elongated by pasting a plurality of ferrite sintered plates with a predetermined gap therebetween as has conventionally been done but an elongate ferrite sheet having a length of not less than 0.3 m and in which a ferrite sintered plate continuously extending in the longitudinal direction of the base material is formed on a surface of the base material. Consequently, the continuity of the ferrite sintered plate is not impaired although the ferrite sheet is elongate, so that the appearance and magnetic properties of the ferrite sheet can be prevented from deteriorating.

The elongate ferrite sheet according to the present disclosure may be a ferrite sheet formed in a roll shape. In the elongate ferrite sheet according to the present disclosure, since the ferrite sintered plate continuously extending in the longitudinal direction of the base material is formed as described above, the continuity of the ferrite sintered plate is not impaired although the ferrite sheet is rolled, and the magnetic properties can be prevented from deteriorating.

Another subject of the present disclosure is a cable on an outer surface of which a noise filter is wound, wherein the noise filter includes any of the above-described elongate ferrite sheets.

Since the cable according to the present disclosure can be produced by continuously winding the above-described elongate ferrite sheet as it is since the ferrite sheet is used as the noise filter, the cable is easy to manufacture and desirable.

An antenna device manufacturing method according to the present disclosure comprises arranging a plurality of antenna base materials each having on a surface thereof a loop coil formed of a conductive material on any of the above-described elongate ferrite sheets according to the present disclosure in a longitudinal direction of the elongate ferrite sheet; attaching the antenna base materials to the elongate ferrite sheet; and cutting the elongate ferrite sheet attaching the antenna base materials to a desired length.

According to an antenna device manufacturing method of the present disclosure, since the above-described elongate ferrite sheet according to the present disclosure is used, an antenna device can be produced by cutting as it is the ferrite sheet attaching a plurality of antenna base materials, which facilitates continuous production of the antenna device.

### ADVANTAGEOUS EFFECTS OF INVENTION

According to the elongate ferrite sheet of the present disclosure, since an elongate ferrite sheet can be obtained in which there is neither overlapping between ferrite sintered plates nor gap between the ferrite sintered plates at the time of pasting of the ferrite sintered plates to the base material, the appearance and magnetic properties of the ferrite sheet can be prevented from deteriorating due to the overlapping and the gap.

### BRIEF DESCRIPTION OF DRAWINGS

FIG. 1 is a plan view showing an elongate ferrite sheet according to an embodiment of the present disclosure.
FIG. 2 is a side view showing a condition where the elongate ferrite sheet according to the embodiment of the present disclosure is rolled, and is an enlarged view showing the lamination structure of the ferrite sheet.

### DESCRIPTION OF EMBODIMENTS

Hereinafter, a mode for carrying out the present disclosure will be described based on the drawings. The following description of a preferred embodiment is essentially nothing but illustrative, and does not intend to restrict the present disclosure, its application method or its use.

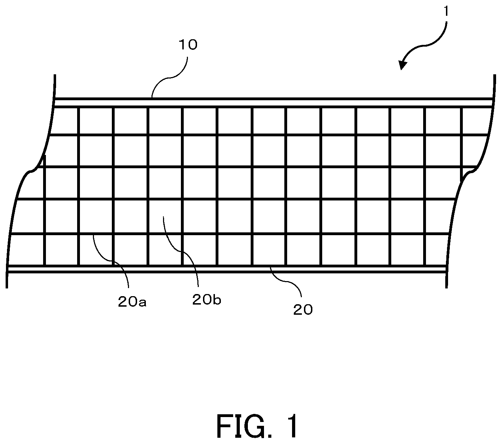

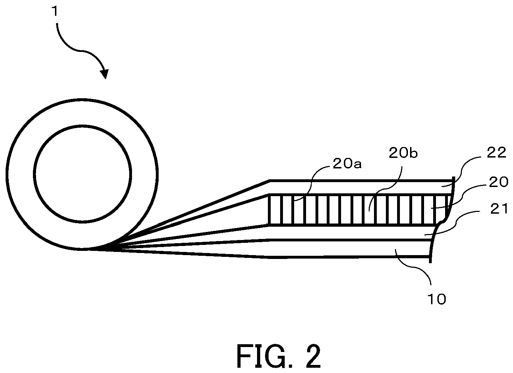

First, an elongate ferrite sheet according to an embodiment of the present disclosure will be described with reference to FIGS. 1 and 2. As shown in FIGS. 1 and 2, a ferrite sheet 1 according to the embodiment of the present disclosure is formed of a base material 10 and one ferrite sintered plate 20 provided on a surface of the base material 10. On the upper and lower surfaces of the ferrite sintered plate 20, adhesive agents 21 and 22 such as double-sided adhesive tape are provided. The ferrite sintered plate 20 is bonded to the base material 10 through the adhesive agent 21.

As the material for the base material 10, although not specifically limited, for example, a resin material such as polyethylene terephthalate (PET) or a metallic material such as aluminum foil may be used. While the base material 10 is provided only on the lower surface in FIG. 1, it may also be provided on the upper surface so as to be bonded to the adhesive agent 22.

While the ferrite sintered plate 20 is a ferrite sintered body formed into a plate and the kind of the ferrite used is not specifically limited as long as it has magnetic properties, for example, Ni-Zn ferrite or Mn-Zn ferrite may be used.

In the ferrite sheet 1 according to the present embodiment, the ferrite sintered plate 20 is formed on a surface of the base material 10 as described above; specifically, the ferrite sintered plate 20 is formed so as to continuously extend in the longitudinal direction of the base material 10. Since this makes it unnecessary to paste a plurality of ferrite sintered plates 20 to the base material 10 with a gap therebetween as has conventionally been done, the continuity of the ferrite sintered plate 20 is not impaired, so that the deterioration of the appearance and magnetic properties of the ferrite sheet 1 due to the gap can be prevented. Moreover, the ferrite sheet 1 is elongate and has a length of not less than 0.3 m. Although it was previously difficult to manufacture a ferrite sintered plate 20 having a length of not less than 0.3 m because of the sizes of the jig and the firing furnace for sintering the ferrite sintered plate 20, a manufacturing method described later makes it possible to produce a ferrite sintered plate 20 being continuous without any gap and having a length of not less than 0.3 m. Thereby, an elongate ferrite sheet 1 can be obtained with neither overlapping between the ferrite sintered plates 20 nor gap between the ferrite sintered plates 20 at the time of pasting of the ferrite sintered plate 20 to the base material. Here, the ferrite sheet 1 has a shape having a longitudinal direction and a transverse direction because it is an elongate sheet, and the size thereof is not specifically limited as long as the longitudinal dimension is not less than 0.3 m; for example, the longitudinal dimension is 0.3 m to 100 m and the transverse dimension is 20 mm to 50 mm. While the thickness of the ferrite sheet 1 is not specifically limited, either, it is preferably 60 to 300 µm.

In the ferrite sheet 1 according to the present embodiment, in order to improve the flexibility of the ferrite sheet 1, the ferrite sintered plate 20 may have cracks 20a. While a plurality of grid-like cracks 20a extending in the longitudinal and lateral directions are provided in FIG. 1, the present disclosure is not limited thereto; they may be irregular cracks. In a case where the grid-like cracks 20a as shown in FIG. 1 are provided, the cracks 20a can be formed, for example, by previously providing grid-like grooves at least on the surface on either side of the ferrite sintered plate 20 and dividing the ferrite sintered plate 20 with the grooves as the starting points. Moreover, the ferrite sintered plate 20 may be divided into a plurality of small pieces 20b by pressurization with a roller or the like without any grooves formed. When grooves are formed, generally, the widths of the openings of the grooves are preferably not more than 250 µm, more preferably 1 to 150 µm. It is unpreferable that the widths of the openings exceed 250 µm because change in the magnetic permeability of the ferrite sintered plate 20 is large. Moreover, the depths of the grooves are generally 1/20 to 3/5 of the thickness of the ferrite sintered plate 20. In the case of a thin ferrite sintered plate 20 with a thickness of 0.1 to 0.2 mm, the depths of the grooves are preferably 1/20 to 1/4, more preferably 1/20 to 1/6 of the thickness of the ferrite sintered plate 20. The adjoining small pieces 20b of the ferrite sintered plates 20 are at least partially in contact with each other with the cracks 20a therebetween.

In the ferrite sheet 1 according to the present embodiment, the ferrite sintered plate 20 is formed so as to continuously extend in the longitudinal direction of the base material 10 as described above. Here, continuously refers to the ferrite sintered plate 20 extending without any cracks other than the above-described cracks 20a. That is, the ferrite sintered plate 20 includes no intentionally provided gap. The gap refers to a gap provided between a plurality of ferrite sintered plates 20 to prevent the ferrite sintered plates 20 from overlapping with each other, and the width of the gap is larger than 0.1 mm.

As described above, according to the ferrite sheet 1 of the present embodiment, since the ferrite sheet 1 is characterized in that the ferrite sintered plate 20 continuously extending in the longitudinal direction of the base material 10 is formed on a surface of the base material 10 and has a length of not less than 0.3 m as described above, an elongate ferrite sheet 1 can be obtained without the continuity of the ferrite sintered plate 20 impaired.

The ferrite sheet 1 according to the present embodiment may freely be cut to a desired length for use because it is elongate. For this reason, unlike rectangular sheets, discarding of unnecessary parts hardly occurs, or the deterioration of the appearance and magnetic properties caused by connecting a plurality of sheets because of an insufficient length never occurs.

According to another embodiment of the present disclosure, the ferrite sheet 1 is a ferrite sheet formed in a roll shape. This facilitates continuous production of an antenna device obtained by arranging a plurality of antenna base materials in order and then, individually cutting them, and also facilitates the winding on a cable or the like. This is also preferable in terms of storage and portability.

The ferrite sheet 1 according to the present embodiment may be applied to a noise filter wound on the outer surface of a cable. It has previously been known that a ferrite sheet can be used as a noise filter for suppressing electromagnetic noise generated from a cable, and in the present embodiment, electromagnetic noise generated from a cable is suppressed by winding the elongate ferrite sheet 1 on the outer surface of the cable. Although the method for winding the ferrite sheet 1 on the outer surface of the cable is not specifically limited, it is preferable in terms of workability to continuously wind the ferrite sheet 1 in a spiral manner in the axial direction of the cable.

Moreover, an antenna device can be manufactured by use of the ferrite sheet 1 according to the present embodiment. A method for manufacturing an antenna device according to the present embodiment is characterized by including: a step in which a plurality of antenna base materials each having on a surface thereof a loop coil formed of a conductive material are arranged on the elongate ferrite sheet having the above-described characteristics in the longitudinal direction of the elongate ferrite sheet; a step in which the antenna base materials are attached to the elongate ferrite sheet; and a step in which the elongate ferrite sheet having the antenna base materials attached thereto is cut to a desired length. With the method for manufacturing the antenna device according to the present embodiment, since the elongate ferrite sheet having the above-described characteristics is used, an antenna device can be produced by cutting as it is the ferrite sheet having a plurality of antenna base materials attached thereto, which facilitates continuous production of the antenna device.

Next, a method for manufacturing the ferrite sheet 1 according to the present embodiment will be described.

First, with respect to 1000 parts by weight of ferrite powder, 70 to 120 parts by weight of polyvinyl alcohol resin, 15 to 25 parts by weight of butylphthalic butyl as a plasticizer and 400 to 600 parts by weight of solvent are mixed to prepare a coating. As the solvent, a glycol ether-based solvent, methyl ethyl ketone (MEK), toluene, methanol, ethanol, n-butanol or the like may be used. When factors such as the dispersibility of the ferrite powder and the workability and drying characteristics of the mixture are considered, the preferred composition range for the coating is as follows: with respect to 1000 parts by weight of ferrite, 80 to 110 parts by weight of polybutyral resin, 18 to 22 parts by weight of butylphthalic butyl, and 450 to 550 parts by weight of the solvent.

While a ball mill, for example, may be used for the manufacture of the coating, the present disclosure is not limited thereto. The solvent and ferrite are filled and mixed first, and then, the resin and the plasticizer are added and mixed, whereby a uniform coating is obtained. It is important that the obtained coating be sufficiently defoamed under reduced pressure in a vacuum container in order to prevent cracks from occurring on the coating film when the coating is applied and dried.

While the method for applying the ferrite-dispersed coating is not specifically limited, a roll coater or a doctor blade may be used. In terms of the film thickness precision and the stability of the coating, a doctor blade is used. The coating is applied to a plastic film to a desired thickness with the doctor blade and is dried for 30 to 60 minutes at 80 to 130 °C, whereby a green sheet can be obtained.

While the plastic film for the application of the ferrite-dispersed coating is not specifically limited, a film may be used that is preferably obtained by sandblasting a film of various kinds such as polyethylene (PE), polypropylene (PP), polyethylene terephthalate (PET) and polyimide. In terms of the processability of the film surface and the heat stability when the coating is applied and dried, a polyethylene terephthalate (PET) film is suitable. The use of the sandblasted plastic film enables the unevenness of the plastic film to be transferred to the green sheet, so that a green sheet with a desired surface unevenness can be obtained.

Then, the obtained green sheet is fired, thereby obtaining the ferrite sintered plate 20. The firing is performed while the green sheet peeled off from the plastic film is rolled. The size of the rolled green sheet is not specifically limited as long as it is a size accommodatable in the firing furnace. As firing conditions, it is important to provide a process of removal of the resin components and particle growth of the ferrite by use of an electric furnace. The resin removal is performed at 150 to 550 °C for five to eighty hours, and the ferrite particle growth is performed at 850 to 1200 °C for one to five hours. To prevent heating deformation and cracks of the sheet, in the resin component removal, after the temperature is increased by approximately 10 to 20 °C per hour from the room temperature, a constant temperature is maintained. Thereafter, preferably, after the temperature is increased by 30 to 60 °C per hour, a constant temperature is maintained and the sheet is sufficiently sintered to grow the ferrite particles and then, gradually cooled. By the process as described above, the ferrite sintered plate 20 is obtained. By the above-described method, the elongate ferrite sintered plate 20 with a length of not less than 0.3 m can be obtained without limited by the sizes of the jig and the firing furnace for producing the ferrite sintered plate 20.

Then, the ferrite sintered plate 20 fired in a roll shape is elongated and bonded to the base material 10 through the adhesive agent 21, thereby obtaining the elongate ferrite sheet 1. The base material 10 may also be provided on the upper surface so as to be bonded to the adhesive agent 22. The obtained elongate ferrite sheet 1 may further be processed into a roll shape.

As described above, the ferrite sintered plate 20 may be divided into small pieces. For the division of the ferrite sintered body into small pieces, for example, a stress may be applied, with a roller or the like, to the ferrite sheet where the ferrite sintered body is held by the base material, thereby dividing the ferrite sintered body, or predetermined grooves may be formed in the stage of the green sheet. The grooves may be either continuous or intermittent, or a multiplicity of minute concaves may be formed and used as a substitute. The sintered body is divided into a given size of triangular, quadrilateral or polygonal shape or a combination thereof according to the previously formed grooves. Moreover, it may be divided into irregular shapes with no grooves formed.

With the method for manufacturing the elongate ferrite sheet according to the present embodiment as described above, by firing the green sheet containing the ferrite material in a rolled state, an elongate ferrite sheet can be obtained that has a length of not less than 0.3 m and in which a ferrite sintered plate continuously extending in the longitudinal direction of the base material is formed on a surface of the base material unlike the conventional ferrite sheet elongated by pasting a plurality of ferrite sintered plates with a predetermined gap therebetween.

As described above, according to the elongate ferrite sheet of the present disclosure, an elongate ferrite sheet with neither overlapping between ferrite sintered plates nor gap between the ferrite sintered plates at the time of pasting of the ferrite sintered plates to the base material can be obtained, can be suitably applied to antenna devices, cables and the like without any property deterioration, and is very useful.

### DESCRIPTION OF REFERENCE CHARACTERS

- 1: Ferrite sheet
- 10: Base material
- 20: Ferrite sintered plate
- 20a: Crack
- 20b: Small piece
- 21, 22: Adhesive agent

## Claims

1. An elongate ferrite sheet comprising:
an elongate base material, and
a ferrite sintered plate provided on a surface of the base material,
wherein the ferrite sintered plate continuously extends in a longitudinal direction of the base material, and
wherein the elongate ferrite sheet has a length of not less than 0.3 m in the longitudinal direction.

2. The elongate ferrite sheet according to claim 1, **characterized by** being formed in a roll shape.

3. A cable on an outer surface of which a noise filter is wound, wherein the noise filter includes the elongate ferrite sheet according to claim 1 or 2.

4. An antenna device manufacturing method comprising:
arranging a plurality of antenna base materials each having on a surface thereof a loop coil formed of a conductive material on the elongate ferrite sheet according to claim 1 or 2 in a longitudinal direction of the elongate ferrite sheet;
attaching the antenna base materials to the elongate ferrite sheet; and
cutting the elongate ferrite sheet attaching the antenna base materials to a desired length.
